# FASCICULE DE BREVET EUROPEEN

(11) **EP 4 158 812 B1**
(45) Date de publication et mention de la délivrance du brevet: **17.09.2025**
(21) Numéro de dépôt: 21733485.3
(22) Date de dépôt: 20.05.2021
(51) Int. Cl.: H04L 1/00, H04L 1/20, H04W 88/08, H03M 1/00, H03M 7/30, H03M 7/50

(54) **PROCEDE ET DISPOSITIF DE QUANTIFICATION DE DONNEES REPRESENTATIVES D'UN SIGNAL RADIO REÇU PAR UNE ANTENNE RADIO D'UN RESEAU MOBILE**
VERFAHREN UND VORRICHTUNG ZUR QUANTISIERUNG VON DATEN, DIE FÜR EIN VON EINER FUNKANTENNE EINES MOBILFUNKNETZES EMPFANGENES FUNKSIGNAL REPRÄSENTATIV SIND
METHOD AND DEVICE FOR QUANTISING DATA REPRESENTATIVE OF A RADIO SIGNAL RECEIVED BY A RADIO ANTENNA OF A MOBILE NETWORK

(30) Priorité: 26.05.2020 FR 2005538
(43) Date de publication de la demande: 05.04.2023
(73) Titulaire: Orange, 92130 Issy-les-Moulineaux (FR)
(72) Inventeur: FERRIEUX, Alexandre, 92326 Châtillon Cedex (FR); GUILLEMIN, Fabrice, 92326 Châtillon Cedex (FR); QUINTUNA RODRIGUEZ, Veronica Karina, 92326 Châtillon Cedex (FR)
(74) Mandataire: Vidon Brevets & Stratégie
(86) Numéro de dépôt international: PCT/FR2021/050903
(87) Numéro de publication internationale: WO 2021/240097

(56) Documents cités:
- LING XINYUE ET AL: "Optimization of Quantization Levels for Quantize-and-Forward Relaying with QAM Signaling", 2018 ASIA-PACIFIC SIGNAL AND INFORMATION PROCESSING ASSOCIATION ANNUAL SUMMIT AND CONFERENCE (APSIPA ASC), APSIPA ORGANIZATION, 12 November 2018 (2018-11-12), pages 159 - 164, XP033525891, DOI: 10.23919/APSIPA.2018.8659534
- MIYAMOTO KENJI ET AL: "Wireless performance and mobile fronthaul bandwidth of uplink joint reception with LLR combining in split-PHY processing", JOURNAL OF COMMUNICATIONS AND NETWORKS, NEW YORK, NY, USA,IEEE, US, vol. 20, no. 6, 1 December 2018 (2018-12-01), pages 536 - 545, XP011706851, ISSN: 1229-2370, [retrieved on 20190120], DOI: 10.1109/JCN.2018.000086
- MIYAMOTO KENJI ET AL: "Unified Design of LLR Quantization and Joint Reception for Mobile Fronthaul Bandwidth Reduction", 2017 IEEE 85TH VEHICULAR TECHNOLOGY CONFERENCE (VTC SPRING), IEEE, 4 June 2017 (2017-06-04), pages 1 - 5, XP033254417, DOI: 10.1109/VTCSPRING.2017.8108426

## Description

### 1. Domaine de l'invention

L'invention concerne le domaine des réseaux cellulaires et plus précisément l'échange d'informations entre différentes fonctions du réseau d'accès radio (RAN pour Radio Access Network en anglais).

### 2. Art Antérieur

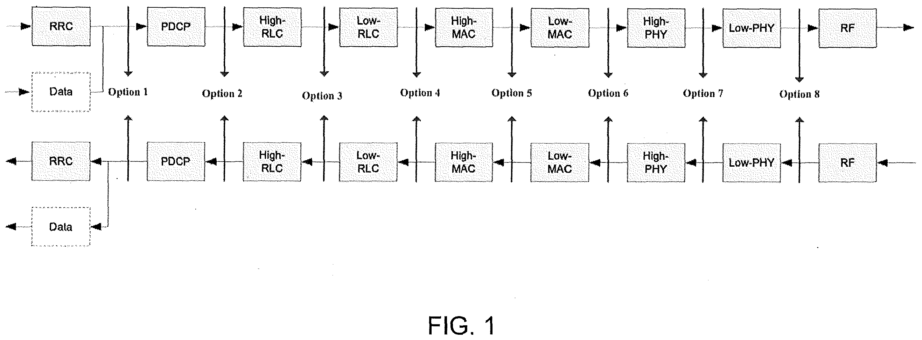

Les fonctions du réseau d'accès radio peuvent être décomposées en plusieurs blocs fonctionnels : PDCP, RLC, MAC, (de)codage, adaptation de débit (Rate Matching en anglais), Modulation, etc. De telles possibilités de décompositions fonctionnelles sont illustrées en figure 1 montrant les options de découpages possibles décrits dans 3GPP (3rd Generation Partnership Project) Study on new radio access technology : Radio access architecutre and interfaces, 3 2017, TR38.801 V14.0.7*.*

Dans les implémentations actuelles, ces différentes fonctions sont exécutées par une même plateforme de calcul qui fait partie d'une station de base (BBU pour Base Band Unit en anglais). Par exemple, une telle plateforme est un serveur dédié au pied d'une antenne.

Or, avec l'évolution des fonctions radio et la centralisation de certaines de ces fonctions au sein de plateformes de calcul centralisées (aussi connue sous le nom de Cloud-RAN) pour notamment réaliser des économies d'échelle et une meilleure gestion des ressources radio, les fonctions du RAN peuvent être scindées selon plusieurs options (cf. la spécification TR 38.801 du 3GPP comme indiqué dans la Figure 1).

Parmi ces options de découpages, un découpage nommé split ou option 7.3 consiste à séparer les fonctions du RAN en au moins deux blocs : les fonctions basses ((dé)modulation, conversion analogique/numérique, FFT, etc.) d'un côté et les fonctions hautes d'un autre côté ((dé)codage, MAC - Media Access Control en anglais-, etc.) dans les sens montant et descendant. Les fonctions RLC (Radio Link Control en anglais) et PDCP (Packet Data Convergence Protocol en anglais) peuvent elles-mêmes être implantées encore plus haut dans le réseau (par un découpage nommé option 2 par exemple).

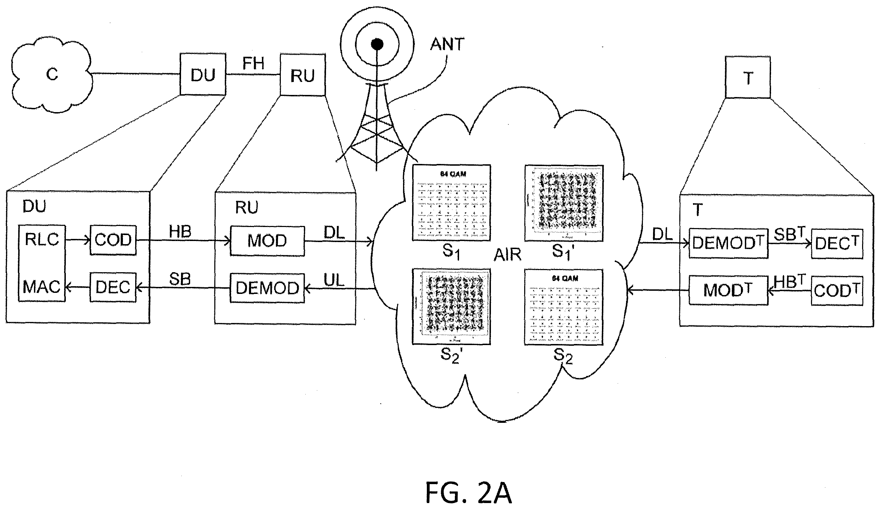

L'option 7.3 est détaillée de manière simplifiée en Figure 2A. Il est à noter que cette option 7.3 n'est considérée par le 3GPP que dans le sens descendant. La figure 2A illustre schématiquement l'échange de données entre un cœur de réseau C et une antenne ANT via laquelle un terminal T émet et reçoit des données. Comme illustrée en figure 2A, les fonctions de modulation/démodulation et de codage/décodage sont mises en œuvre dans des équipements séparés. Par exemple, les fonctions de modulation (MOD) dans le sens descendant (DL, downlink en anglais) et de démodulation (DEMOD) dans le sens ascendant (UL, uplink en anglais) sont mises en œuvre par un premier équipement (RU) et les fonctions de codage (COD), de décodage (DEC), RLC et MAC sont mises en œuvre par un deuxième équipement (DU), les fonctions hautes PDCP, RRC sont mises en œuvre par un troisième équipement (CU, non représenté). Dans le sens descendant DL, le module d'encodage (COD) transmet des données HB sous la forme de « hard bits » au module de modulation (MOD). Ces données HB hard bits sont des séquences binaires issues du codage canal mis en œuvre pour la transmission sur le réseau mobile des données source reçues du cœur de réseau. Le module de modulation (MOD) émet ensuite des symboles modulés I/Q.

Dans le sens ascendant UL, le module de démodulation (DEMOD) reçoit des symboles I/Q qu'il démodule sous la forme de données SB dits « soft bits ». Le module de démodulation (DEMOD) transmet ces soft bits SBau module de décodage (DEC). Ces données SB soft bits sont des données réelles, et non binaires.

Les opérations inverses se déroulent dans le terminal T. En effet, le terminal T reçoit des symboles modulées I/Q en provenance de la station de base, i.e. dans le sens descendant DL, qui sont démodulés par le module de démodulation du terminal (DEMOD^{T}) sous la forme de soft bits (SB^{T}). Le module de démodulation (DEMOD^{T})transmet ces « soft bits » (SB^{T}) au module de décodage du terminal (DEC^{T}).

Lors de l'émission de données par le terminal à la station de base, i.e. dans le sens ascendant UL, le module d'encodage du terminal (COD^{T}) transmet des hard bits (HB^{T}) au module de modulation du terminal (MOD^{T}) qui les module en symboles modulées I/Q qui sont ensuite émis sur le canal radio.

Des exemples de signaux I/Q sont schématiquement illustrés en figure 2A. Par exemple, la figure 2A montre :
- un signal radio-fréquence I/Q S₁ émis par la station de base ANT et le signal radio-fréquence I/Q correspondant S₁' reçu par le terminal T, et
- un signal radio-fréquence I/Q S₂ émis par le terminal T et le signal radio-fréquence I/Q correspondant S₂' reçu par la station de base ANT.

Il apparaît que les signaux reçus S₁' et S₂' sont bruités par rapport aux signaux émis correspondant S₁ et S₂.

Pour des raisons d'efficacité du décodage canal, les modules de démodulations respectivement de l'antenne et du terminal transmettent donc au module de décodage canal des données démodulées communément appelées soft bits. Les soft bits représentent les rapports de vraisemblance logarithmique (Log Likehood Ratio en anglais ou LLR) des symboles IQ reçus par l'antenne de la station de base ou du terminal après démodulation du signal reçu. Autrement dit, le signal LLR représente le ratio entre la probabilité qu'un bit particulier du signal reçu soit un 1 et la probabilité que ce bit soit un 0. L'utilisation de données LLR par le module de décodage permet d'obtenir de bonnes performances pour les méthodes de décodage canal.

Dans la plupart des implémentations, ces données LLR sont codées sur 16 ou 12 bits. Lorsque les LLR sont traités localement, i.e. que les fonctions de démodulation et de décodage sont mises en œuvre par un même équipement, cette représentation ne pose pas de problème. Toutefois, certains découpages des fonctions réseau, comme illustré en figure 2A, proposent de séparer la fonction de démodulation et la fonction de décodage. Les données LLR doivent alors être transportées entre des fonctions hautes et basses du RAN.

Des exemples de débits requis pour transmettre les données LLR sont illustrés par le tableau 1 ci-dessous pour une modulation 64 QAM. Ce débit varie en fonction du niveau de codage ou schéma de codage et modulation MCS (pour Modulation and Coding Scheme).

Il apparaît clairement que les débits peuvent atteindre des valeurs très grandes, ce qui peut poser des problèmes de dimensionnement pour le réseau fronthaul (première partie du réseau d'accès), qui relie les fonctions hautes aux fonctions basses.

### [Table 1]

**Tableau 1. Débit requis sur le fronthaul en fonction du niveau de codage des LLR pour une modulation 64QAM.**

| **Niveau de codage des LLR** | **Débit [Gbps]** |
|---|---|
| 1 | 4.05 |
| 2 | 8.10 |
| 3 | 12.15 |
| 4 | 16.20 |
| 5 | 20.25 |
| 6 | 24.30 |
| 7 | 28.35 |
| 8 | 32.40 |
| 9 | 36.45 |
| 10 | 40.50 |
| 11 | 44.55 |
| 12 | 48.60 |
| 13 | 52.65 |
| 14 | 56.70 |
| 15 | 60.75 |

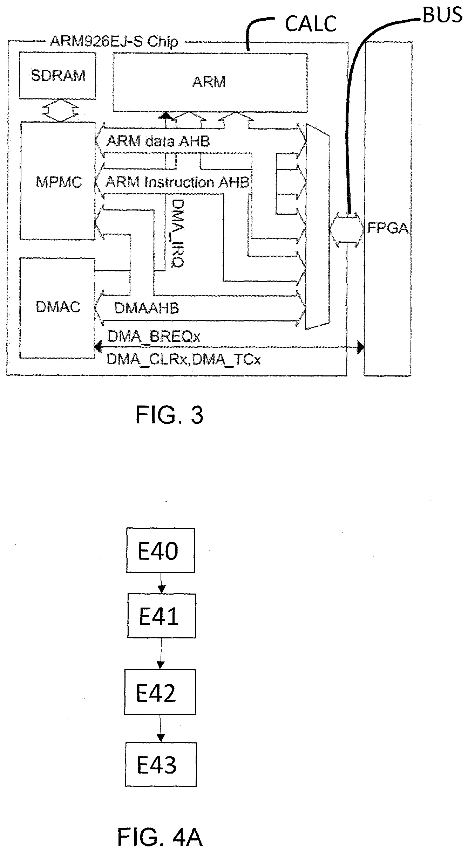

Un tel problème apparaît également quand les fonctions de codage/décodage sont déportées dans un composant FPGA (pour Field Programmable Gate Arrays en anglais) pour gagner en temps de calcul, comme par exemple illustré en figure 3. La figure 3 illustre un composant FPGA pour le codage/décodage et une plateforme de calcul CALC exécutant les autres fonctions du RAN. Selon une telle mise en œuvre, les soft bits sont transférés au composant FPGA par un bus de communication (BUS). Le débit nécessaire à la transmission des soft bits est un frein à de telles mises en œuvre, car les bus de communication ne sont pas adaptés pour transmettre de telles quantités de données avec une latence raisonnable vis-à-vis des contraintes de service.

Des techniques antérieures consistent à transférer des symboles I/Q, donc avant la démodulation, entre les fonctions hautes et basses du RAN, notamment dans l'option 7.2 retenu par ORAN. Pour réduire la bande passante entre les deux groupes de fonctions du RAN, la méthode ORAN propose de compresser les symboles I/Q transportés entre les fonctions hautes et basses du RAN. Plusieurs méthodes de compression sont identifiées dans la spécification ORAN-WG4.CUS.0-v02.00 d'ORAN (O-RAN Fronthaul Working Group, "Control, User and Synchronization Plane Specification," O-RAN, Specification, 2019)*.* Toutefois, ces méthodes conduisent à une dégradation importante du signal radio, ce qui semble totalement irréaliste dans un contexte opérationnel.

Il existe donc un besoin d'améliorer l'état de la technique.

*"*Optimization of Quantization Levels for Quantize-and-Forward Relaying with QAM Signaling", de Ling et al., APSIPA ASC 2018*,* divulgue un système coopératif de quantification de données reçues par des relais d'un réseau C-RAN dans lequel les LLR quantifiées sont transmises par fibre large bande à un décodeur unique et le niveau de quantification est adapté selon un schéma MCS reposant sur une optimisation conjointe de l'information mutuelle et de la quantité de trafic.

*"*Wireless performance and mobile fronthaul bandwidth of uplink joint reception with LLR combining in split-PHY processing", de Miyamoto et al., IEEE Journal of Communications and Networks, 01.12.2018*,* étudie les performances du traitement de la couche physique partagée, avec la combinaison LLR en transmission CoMP dans un C-RAN, en termes de SNR, de débit et de largeur de bande MFH par rapport aux systèmes conventionnels.

*"*Unified Design of LLR Quantization and Joint Reception for Mobile Fronthaul Bandwidth Reduction" de Miyamoto et al., Proceedings of the IEEE 85th, VTC Spring 2017 - 14.11.2017*,* divulgue la possibilité de réduire la largeur de bande MFH en utilisant une conception unifiée de la quantification LLR et de la réception conjointe, avec des seuils de quantification adaptés au SNR et à la capacité de codage des données LLR quantifiés.

### 3. Exposé de l'invention

L'invention vient améliorer l'état de la technique. Elle concerne à cet effet, un procédé de quantification de données représentatives d'un signal radio reçu par une antenne radio d'un réseau mobile, comprenant la démodulation dudit signal radio reçu par ladite antenne, fournissant un signal démodulé, la quantification scalaire de chaque valeur dudit signal démodulé à l'aide d'une table de quantification sélectionnée en fonction d'un niveau de codage canal utilisé pour transmettre ledit signal radio, fournissant un signal démodulé quantifié, et la transmission dudit signal démodulé quantifié à un module de décodage canal.

L'invention permet ainsi de réduire le débit nécessaire à la transmission des soft bits entre le module de démodulation et le module de décodage canal, notamment lorsque ces modules sont mis en œuvre sur deux équipements distincts.

Dans le cas où le processus de décodage est mis en œuvre par un circuit spécifique, de type FPGA, la réduction de la taille de codage des softbits ou LLRs permet de réduire la bande passante sur le bus de communication entre le composant FPGA et le reste des fonctions du RAN et ainsi de gagner un facteur possible de multiplexage si plusieurs composants FPGA sont connectés au bus de communication.

Avantageusement, le procédé de quantification selon l'invention tient compte d'un niveau de codage du signal radio reçu afin de quantifier les soft bits de manière adaptative en fonction de ce niveau de codage. En effet, les fonctions de codage canal ne sont pas déterministes et varient en fonction des conditions du canal radio des terminaux connectés à l'antenne, de la charge des données par terminal et de la quantité de trafic dans la cellule.

Selon un mode particulier de réalisation de l'invention, chaque valeur dudit signal démodulé est représentative d'un rapport de vraisemblance logarithmique d'un symbole dudit signal radio reçu par ladite antenne.

Selon un autre mode particulier de réalisation de l'invention, le niveau de codage canal correspond à un index représentatif d'une combinaison d'un schéma de modulation et d'un taux de codage canal. Selon ce mode particulier de réalisation de l'invention, le niveau de codage canal correspond à un index MCS indiquant le schéma de modulation et le taux de codage canal utilisé pour transmettre le signal radio entre l'antenne et un terminal connecté à l'antenne. Le taux de codage est défini comme le nombre de bit par symbole modulé. Le schéma de codage et modulation (MCS) est une fonction de codage qui associe un mot de code de N symboles modulés à un bloc d'information de taille D bits utiles. Le taux de codage du MCS est alors le rapport D/N et s'exprime en bits/symbole.

Selon un mode particulier de réalisation de l'invention telle que revendiquée, le procédé de quantification comprend au préalable, la détermination, pour chaque niveau de codage canal, d'au moins une table de quantification scalaire à partir d'un ensemble de signaux radio d'apprentissage. Selon ce mode particulier de réalisation de l'invention, la table de quantification scalaire est déterminée au préalable lors d'une phase d'apprentissage à partir de signaux radio réels. Ceci permet d'avoir une table de quantification adaptée aux conditions réelles de transmission radio. Cette table de quantification est déterminée en mode off-line. Ainsi, des méthodes d'optimisation de la table de quantification coûteuse en temps de calcul, voire nécessitant du matériel de traitement adapté peuvent être utilisées.

Selon un autre mode particulier de réalisation de l'invention, la détermination de ladite au moins une table de quantification scalaire comprend une minimisation d'un taux d'erreur de décodage canal des signaux radio d'apprentissage. Ainsi, la table de quantification est déterminée de sorte à optimiser le BLER des signaux radio d'apprentissage. Avantageusement, ce mode particulier de réalisation de l'invention tient compte des performances du décodage canal. La table de quantification est ainsi optimisée de bout en bout en fonction du critère de qualité du décodage des soft bits.

Selon un autre mode particulier de réalisation de l'invention, la détermination de ladite au moins une table de quantification scalaire comprend l'estimation d'une distribution de la valeur absolue des valeurs du signal radio démodulé, et, pour au moins un niveau de quantification correspondant à une représentation des valeurs quantifiées du signal démodulé quantifié sur un nombre déterminé de bits, le calcul d'intervalles de quantification à partir de ladite distribution estimée, chaque intervalle de quantification comprenant sensiblement un même nombre de valeurs du signal radio démodulé.

Selon ce mode particulier de réalisation de l'invention, la table de quantification est déterminée à partir de la distribution des valeurs absolues des soft bits. Ceci permet d'obtenir des intervalles de quantification adaptés à la densité des valeurs à quantifier. Ainsi, moins une zone de la distribution des valeurs est peuplée (autrement dit cette zone comprend un faible nombre d'échantillons), plus les intervalles de quantification dans cette zone seront grands. Au contraire, pour une zone fortement peuplée, i.e. une zone comprenant un nombre important d'échantillons, les intervalles de quantification sont petits. Ceci permet de limiter le taux d'erreurs dû à la quantification du signal radio démodulé. Par exemple, une telle détermination est une méthode de type « companding » en anglais. Ce type de méthode permet d'obtenir rapidement des tables de quantification.

Selon un autre mode particulier de réalisation de l'invention, le calcul des intervalles de quantification est réalisé à l'aide d'une méthode de type Lloyd-Max. Une telle méthode est plus complexe qu'une méthode de companding, mais permet d'obtenir des tables de quantification plus optimales qu'avec une méthode de companding.

Selon un autre mode particulier de réalisation de l'invention, la détermination de ladite au moins une table de quantification scalaire comprend les sous-étapes suivantes :
- détermination d'un ensemble de vecteurs de quantification candidats, et
- pour chaque vecteur de quantification candidat :
   - quantification des signaux radio démodulés d'apprentissage à l'aide dudit vecteur de quantification, fournissant des signaux radio démodulés d'apprentissage quantifiés,
   - calcul d'une distorsion à partir desdits signaux radio démodulés d'apprentissage quantifiés,
- sélection du vecteur de quantification dudit ensemble minimisant ladite distorsion.

En variante de cet autre mode particulier de réalisation de l'invention, la détermination de ladite au moins une table de quantification scalaire comprend en outre le décodage desdits signaux radio démodulés d'apprentissage quantifiés selon le niveau de codage canal déterminé, et dans lequel la distorsion est calculée entre lesdits signaux radio démodulés d'apprentissage quantifiés décodés et lesdits signaux radio démodulés d'apprentissage décodés non quantifiés.

Selon une autre variante, les sous-étapes mentionnées ci-dessus sont itérées et à chaque itération, ledit ensemble de vecteurs de quantification candidats est modifié selon un algorithme génétique. Ce type d'algorithme permet d'obtenir un vecteur de quantification sélectionné est optimal. En effet, la méthode d'optimisation basée sur un algorithme génétique permet une amélioration progressive de l'adéquation du vecteur de quantification candidat. Toutefois, ce type de méthodes a un coût calculatoire important.

Selon un autre mode particulier de réalisation de l'invention, au moins deux tables de quantification scalaire sont respectivement déterminées pour au moins deux niveaux de quantification. Le procédé comprend en outre la sélection d'un niveau de quantification parmi les au moins deux niveaux de quantification, minimisant un coût débit-distorsion, où le débit correspond au débit utilisé pour représenter les valeurs quantifiées et la distorsion est calculée entre les valeurs du signal radio démodulé et les valeurs quantifiées. Selon ce mode particulier de réalisation de l'invention, plusieurs niveaux de quantification sont testés et le niveau de quantification offrant le meilleur compromis débit-distorsion est sélectionné pour la quantification.

L'invention concerne corrélativement un procédé de quantification inverse d'un signal démodulé quantifié, mis en œuvre par un module de décodage canal, comprenant la réception du signal démodulé quantifié en provenance d'un module de démodulation configuré pour démoduler un signal radio reçu par une antenne radio d'un réseau mobile, la quantification scalaire inverse de chaque valeur dudit signal démodulé quantifié à l'aide d'une table de dé-quantification sélectionnée en fonction d'un niveau de codage canal utilisé pour transmettre ledit signal radio, fournissant un signal démodulé dé-quantifié, et le décodage canal dudit signal démodulé dé-quantifié.

L'invention concerne aussi un dispositif de quantification de données représentatives d'un signal radio reçu par une antenne radio d'un réseau mobile. Un tel dispositif comprend un module de démodulation configuré pour démoduler ledit signal radio reçu par ladite antenne, fournissant un signal démodulé, un processeur et une mémoire configurés pour quantifier chaque valeur dudit signal démodulé à l'aide d'une table de quantification scalaire sélectionnée en fonction d'un niveau de codage canal utilisé pour transmettre ledit signal radio, fournissant un signal démodulé quantifié, et un module de transmission configuré pour transmettre ledit signal démodulé quantifié à un module de décodage canal.

L'invention concerne aussi un dispositif de décodage canal comprenant
- un récepteur d'un signal démodulé quantifié en provenance d'un module de démodulation configuré pour démoduler un signal radio reçu par une antenne radio d'un réseau mobile,
- un processeur et une mémoire configurés pour :
   - appliquer une quantification scalaire inverse à chaque valeur dudit signal démodulé quantifié à l'aide d'une table de dé-quantification sélectionnée en fonction d'un niveau de codage canal utilisé pour transmettre ledit signal radio, fournissant un signal démodulé dé-quantifié, et
      - appliquer un décodage canal dudit signal démodulé dé-quantifié.

L'invention concerne aussi un dispositif d'un réseau mobile comprenant :
- au moins un dispositif de quantification cité précédemment,
- au moins un dispositif de décodage canal sous la forme d'un circuit programmable configuré pour mettre en œuvre un schéma de décodage canal du signal démodulé dé-quantifié, et
- au moins un bus de communication apte à transmettre le signal démodulé quantifié depuis le dispositif de quantification vers le dispositif de décodage canal.

L'invention concerne également un serveur comprenant au moins un dispositif de quantification cité précédemment ou un dispositif de réseau mobile cité ci-dessus.

L'invention concerne aussi un système de réseau mobile comprenant :
- au moins une antenne radio, configurée pour recevoir un signal radio,
- au moins un équipement de mise en œuvre de fonctions basses du réseau mobile, comprenant au moins un dispositif de quantification tel que cité ci-dessus, et
- au moins un équipement de mise en œuvre de fonctions hautes du réseau mobile, comprenant au moins un dispositif de décodage canal configuré pour décoder un signal démodulé quantifié transmis par le dispositif de quantification.

L'invention concerne également un programme d'ordinateur comportant des instructions pour la mise en œuvre du procédé quantification ou du procédé de quantification inverse cités ci-dessus selon l'un quelconque des modes particuliers de réalisation décrits précédemment, lorsque ledit programme est exécuté par un processeur. Ces procédés peuvent être mis en œuvre de diverses manières, notamment sous forme câblée ou sous forme logicielle.

Ces programmes peuvent utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'enregistrement ou support d'informations lisible par un ordinateur, et comportant des instructions d'un programme d'ordinateur tel que mentionné ci-dessus. Les supports d'enregistrement mentionnés ci-avant peuvent être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple un disque dur. D'autre part, les supports d'enregistrement peuvent correspondre à un support transmissible tel qu'un signal électrique ou optique, qui peut être acheminé via un câble électrique ou optique, par radio ou par d'autres moyens. Les programmes selon l'invention peuvent être en particulier téléchargés sur un réseau de type Internet.

Alternativement, les supports d'enregistrement peuvent correspondre à un circuit intégré dans lequel le programme est incorporé, le circuit étant adapté pour exécuter ou pour être utilisé dans l'exécution du procédé en question.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
[Fig. 1] La figure 1 illustre schématiquement différentes options de découpage des fonctions du RAN,
[Fig. 2A] La figure 2A illustre schématiquement l'émission et la réception de données selon le découpage des fonctions du RAN selon l'option 7.3,
[Fig. 2B] La figure 2B compare schématiquement le découpage des fonctions du RAN selon l'option 7.2 et l'option 7.3,
[Fig. 3] La figure 3 illustre schématiquement un composant FPGA pour le codage/décodage et une plateforme de calcul CALC exécutant les autres fonctions du RAN,
[Fig. 4A] La figure 4A illustre schématiquement des étapes du procédé de quantification selon un mode particulier de réalisation de l'invention,
[Fig. 4B] La figure 4B illustre schématiquement des étapes pour déterminer la table de quantification utilisée dans le procédé de quantification selon un mode particulier de réalisation de l'invention,
[Fig. 5] La figure 5 illustre un exemple de distribution cumulative de probabilité des LLRs en fonction du niveau de codage canal,
[Fig. 6] La figure 6 illustre un exemple de densité de probabilité des LLRs pour des niveaux de codage canal 2, 13 et 24,
[Fig. 7] La figure 7 illustre des exemples de grains de quantification pour le niveau de codage canal 13,
[Fig. 8] La figure 8 illustre une comparaison du BLER avant et après quantification des LLRs.
[Fig. 9] La figure 9 illustre schématiquement des étapes pour déterminer la table de quantification utilisée dans le procédé de quantification selon un autre mode particulier de réalisation de l'invention,
[Fig. 10] La figure 10 illustre schématiquement des étapes du procédé de quantification inverse selon un mode particulier de réalisation de l'invention,
[Fig. 11A] La figure 11A illustre schématiquement un dispositif de quantification selon un mode particulier de réalisation de l'invention,
[Fig. 11B] La figure 11B illustre schématiquement un dispositif de réseau mobile selon un mode particulier de réalisation de l'invention,
[Fig. 12] La figure 12 illustre schématiquement un dispositif de quantification inverse selon un mode particulier de réalisation de l'invention.

### 5. Description d'un mode de réalisation de l'invention

La désagrégation du RAN soulève depuis son introduction des questions relatives au dimensionnement du réseau connectant les fonctions hautes et basses du RAN, aussi appelé fronthaul. Le premier découpage de ces fonctions introduit dans le contexte du RAN, à savoir l'option 8, produisait des débits gigantesques, de l'ordre de 10 Gbit/s par cellule radio, sachant qu'une antenne est typiquement équipée de 3 cellules couvant 120°.

Par la suite, d'autres découpages ont été introduits, notamment l'option 2 permettant de gérer le passage d'un terminal mobile d'une cellule à l'autre (appelé hand-over en anglais) de manière centralisée et ainsi de se passer de l'interface X2. Mais cette découpe ne permet pas de centraliser l'allocation de bande passante radio et le codage pour mieux exploiter les ressources radio.

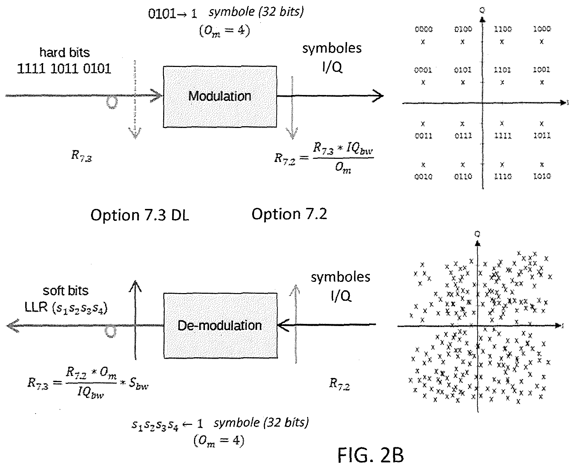

C'est pourquoi la famille des options 7.x a été introduite. L'option 7.2 est notamment considéré par l'alliance de normalisation O-RAN . Mais, comme illustré en figure 2B, l'option 7.2 consiste à transporter des symboles I/Q entre les fonctions hautes et basses du RAN, ce qui peut engendrer des débits toujours très importants sur le réseau fronthaul.

Pour remédier à ce problème, l'option 7.3 a été proposée dans V. Quintuna et al. « Cloud-RAN functional split for an efficient frontaul network », 2020, IWCMC. L'option 7.3, illustrée en figure 2B également, consiste à transférer des hard bits dans le sens descendant et des soft bits (LLR) dans le sens remontant. L'option 7.3 est également illustrée en figure 2A déjà discutée. Une comparaison de débits entre les options 7.2 et 7.3 est fournie dans les tables 2, 3 et 4 ci-dessous.

### [Table 2]

**Table 2 : Débits en Gbit/s des options (splits) 7.2 et 7.3 (MIMO 8, I/Qs avec 16 bits, softbits avec 5 bits).**

| | **Modulation** | **Option 7.2** | **Option 7.3** |
|---|---|---|---|
| **Downlink (sens descendant)** | **256 QAM** | 22.2 | 4.1 |
| **Uplink (sens remontant)** | **64 QAM** | 21.6 | 20.25 |

### [Table 3]

**Table 3 : Comparaison des débits des options (splits) 7.2 et 7.3 (sens descendant)**

| **Modulation** | **7.2/7.3** |
|---|---|
| QPSK (2) | 16 |
| 16 QAM (4) | 8 |
| 64 QAM (6) | 5.3 |
| 256 QAM (8) | 4 |

### [Table 4]

**Table 4 : Comparaison des débits des options (splits) 7.2 et 7.3 (sens montant).**

| **Modulation** | **7.2/7.3 (codage avec 8 bits)** | **7.2/7.3 (codage avec 4 bits)** |
|---|---|---|
| QPSK (2) | 2 | 4 |
| 16 QAM (4) | 1 | 2 |
| 64 QAM (6) | 0.7 | 1.3 |
| 256 QAM (8) | 0.5 | 1 |

Il apparaît clairement que même avec l'option 7.3, les débits dans le sens montant peuvent être très élevés.

Le principe général de l'invention consiste à introduire un codage variable des LLRs en fonction du niveau de codage, tout en ne dégradant pas les performances globales du codage (Bloc Error Rate en anglais pour BLER).

L'invention propose ainsi un procédé de quantification de données représentatives d'un signal radio reçu par une antenne radio d'un réseau mobile.

La figure 4A illustre schématiquement des étapes du procédé de quantification de données représentatives d'un signal radio reçu par une antenne radio d'un réseau mobile, selon un mode particulier de réalisation de l'invention. Par exemple, le procédé est mis en œuvre par le module de démodulation de la station de base ou du terminal illustré en figure 2A.

Lors d'une étape E40, au moins une table de quantification scalaire est déterminée à partir d'un ensemble de signaux radio d'apprentissage conformément à l'invention telle que revendiquée. Cette étape est réalisée lors d'une phase d'apprentissage. Selon un mode particulier de réalisation de l'invention telle que revendiquée, une table de quantification scalaire est déterminée pour chaque niveau de codage canal.

Par niveau de codage canal, on entend ici un index représentatif d'une combinaison d'un schéma de modulation et d'un taux de codage canal ou MCS pour Modulation and Coding Scheme en anglais. Cet index est échangé entre l'antenne et le terminal lors de la transmission des données. Il est connu du module de démodulation et du module de décodage canal.

A l'issue de la phase d'apprentissage, la table de quantification déterminée pour chaque niveau de codage canal est stockée dans une mémoire du module de démodulation.

Lors d'une étape E41, le signal radio reçu par l'antenne de la station de base ou du terminal est démodulé. Le signal radiofréquence reçu, comprenant classiquement des symboles I/Q , est démodulé pour fournir un signal démodulé sous la forme de soft bits ou LLRs. Chaque valeur de ce signal démodulé correspond à un rapport de vraisemblance logarithmique d'un symbole du signal radio reçu par l'antenne.

Lors d'une étape E42, chaque valeur du signal démodulé est quantifiée à l'aide d'une table de quantification stockée dans la mémoire du module de démodulation.

Selon le mode particulier de réalisation de l'invention décrit ici, une table de quantification distincte est stockée pour chaque niveau de codage canal MCS, variant de 1 à 28.

Lors de l'étape E42, la table de quantification correspondant au niveau de codage canal utilisé pour transmettre le signal radio reçu est sélectionnée pour quantifier le signal démodulé.

Un signal démodulé quantifié est obtenu à l'issue de l'étape E42.

Lors d'une étape E43, le signal démodulé quantifié est transmis au module de décodage canal pour reconstruire le signal radio émis initialement.

Le procédé de quantification permet ainsi de réduire la taille du signal démodulé transmis au module de décodage canal.

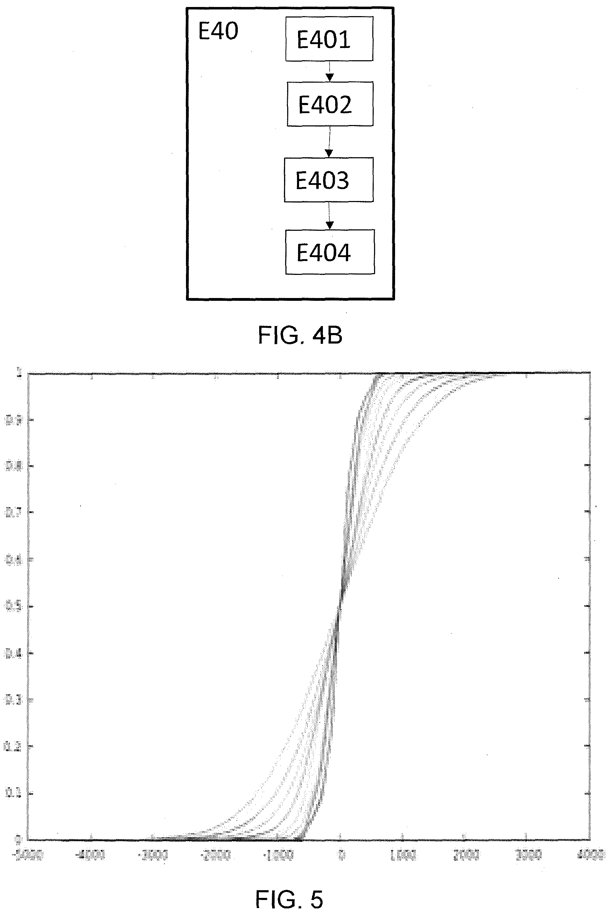

On présente ci-après en relation avec la figure 4B des étapes pour déterminer (E40) la ou les tables de quantification utilisée(s) dans le procédé de quantification décrit ci-dessus.

Selon différentes variantes, une table de quantification unique peut être déterminée pour tous les niveaux de codage canal, ou bien une table de quantification pour être déterminée pour chaque niveau de codage canal. On décrit ici la variante selon laquelle une table de quantification est déterminée pour chaque niveau de codage canal.

Selon le mode particulier de réalisation décrit ici, la table de quantification est déterminée par une méthode de compension ou companding en anglais. La Figure 5 illustre un exemple de distribution cumulative de probabilités de LLRs en fonctions du MCS (niveau de codage) obtenue par simulation avec le code open source OAI (pour Open Air Interface en anglais). Sur la figure 5, le MCS varie de 1 à 28. La figure 5 montre que la distribution est plus piquée quand le MCS croît et que la distribution est symétrique par rapport à 0, grâce au brouillage de niveau bit, ou « scrambling » en anglais.

Comme la distribution des LLRs n'est pas uniforme et varie en fonction du MCS, la technique de companding est utilisée pour chaque MCS.

Les étapes suivantes sont mises œuvre pour chaque niveau de codage canal MCS.

Ainsi, on considère, pour chaque niveau de codage canal, un ensemble de signaux radiofréquence d'apprentissage reçus par une antenne et démodulés fournissant un ensemble de signaux radio démodulés. Cet ensemble de signaux radiofréquence d'apprentissage est utilisé pour estimer la distribution de la valeur absolue des LLRs pour chaque MCS.

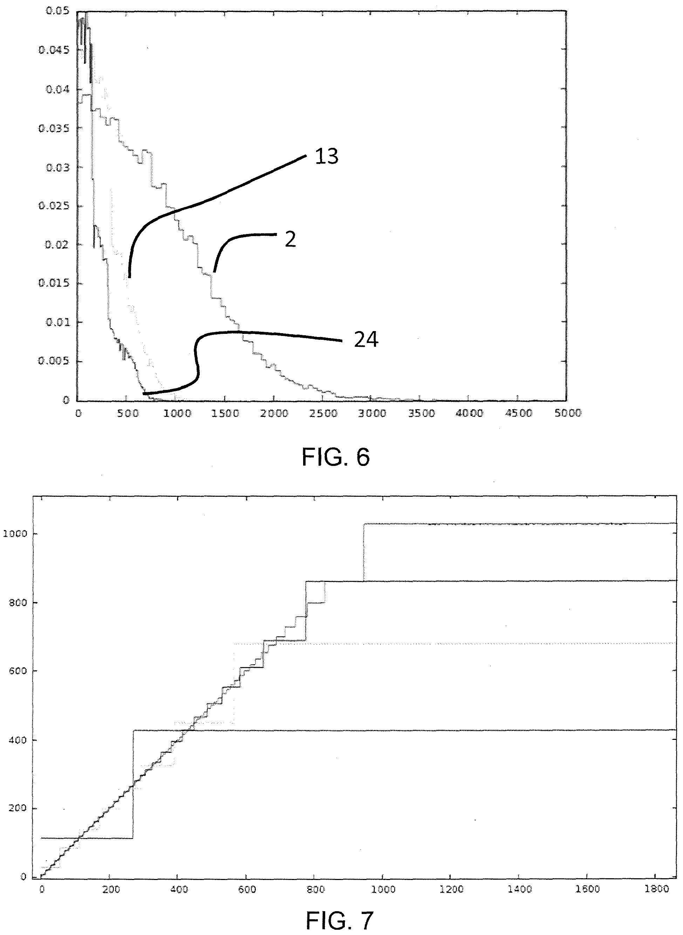

Lors d'une étape E401, la distribution de la valeur absolue des valeurs des signaux radio démodulés est estimée pour chaque MCS. La figure 6 illustre un exemple de densité de probabilité des LLRs pour des niveaux de codage canal 2, 13 et 24. Lors d'une étape E402, pour au moins un niveau de quantification correspondant à une représentation des valeurs quantifiées du signal démodulé quantifié sur un nombre déterminé de bits, des intervalles de quantification sont calculés à partir de la distribution estimée pour chaque niveau de codage canal.

Lors de l'étape E402, une quantification scalaire optimale pour chaque niveau de codage canal est déterminée. Cette quantification optimale est réalisée par la méthode de companding, qui consiste à produire des godets ou bins équiprobables à partir de la distribution non uniforme estimée lors de l'étape E401. Autrement dit, la méthode de companding détermine des intervalles de quantification qui comprennent sensiblement un même nombre de valeurs du signal radio démodulé.

Pour obtenir ces intervalles de quantification, la transformation non linéaire requise est l'inversion de la distribution cumulative de probabilités. Elle s'obtient en pratique par un tri suivi d'un regroupement régulier en bins. Le résultat est un référentiel de quantification ou liste de godets.

Un exemple de liste de godets ou intervalles de quantification est illustré par la Figure 7 pour le MCS 13 et différents niveaux de quantification correspondant respectivement à 2, 8, 32, et 128. On observe que le niveau de quantification correspond au nombre de godets obtenus. Par exemple, une quantification à 2 niveaux de quantification utilise deux intervalles de quantification.

L'étape E402 est mise en œuvre pour chaque niveau de codage et pour différents niveaux de quantification, par exemple les niveaux 2, 8, 32 et 128.

Pour chaque niveau de codage canal, on obtient ainsi une table de quantification par niveau de quantification. Chaque table de quantification comprend les intervalles de quantification des valeurs du signal d'entrée et associe à chaque intervalle de quantification, l'index associé à la valeur quantifiée représentant les valeurs de cet intervalle de quantification.

Lors d'une étape E403, pour chaque niveau de codage canal, une table de quantification est sélectionnée parmi les tables de quantification obtenues pour ce niveau de codage canal.

La table de quantification est sélectionnée de sorte qu'elle minimise un coût débit-distorsion, où le débit correspond au débit utilisé pour représenter les valeurs quantifiées et la distorsion est calculée entre les valeurs du signal radio démodulé et les valeurs quantifiées.

Selon une autre variante, la table peut être sélectionnée en considérant l'erreur de décodage canal introduite par la quantification. L'erreur de décodage peut en effet être mesurée pour vérifier que la quantification du signal LLRs ne dégrade pas les performances globales du codage canal. L'erreur de décodage canal est par exemple mesurée par le BLER pour Block Error Rate en anglais, à partir du signal décodé par le module de décodage canal.

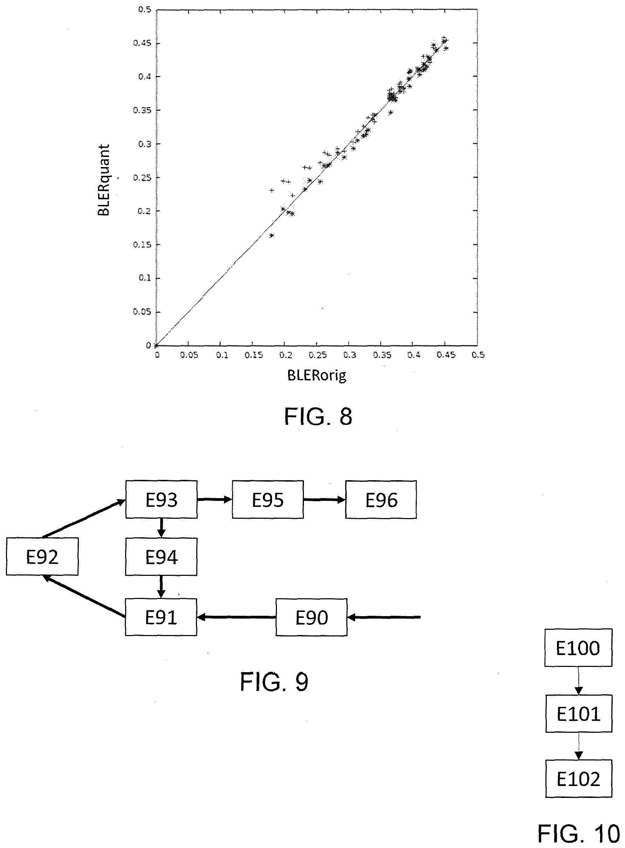

La figure 8 illustre une comparaison du BLER avant (BLERorig) et après la quantification des LLRs (BLERquant) pour différentes niveaux de quantification (2, 4 et 8). Dans la Figure 8, on observe qu'une quantification reposant sur 8 bins offre un bon compromis, induisant une erreur supplémentaire minime tout en permettant un encodage des LLRs sur 4 bits (1bit de signe + 3 bits de valeur absolue). Ce qui permet de réduire la bande passante pour transporter les LLRs d'un facteur 4 par rapport au codage initial sur 16 bits.

Lors d'une étape E404, la table de quantification sélectionnée pour chaque MCS est stockée dans une mémoire du module de démodulation.

Selon le mode particulier de réalisation décrit ici, la détermination de la table de quantification a été réalisée par une méthode de « companding ». D'autres variantes de réalisation de l'invention sont possibles pour obtenir la table de quantification. Notamment, une méthode de type Lloyd-Max peut être utilisée pour définir les intervalles de quantification.

La méthode de Lloyd-Max détermine un quantifieur scalaire optimal en minimisant une distorsion. Une telle distorsion est calculée entre le signal d'entrée, i.e. les valeurs absolues des valeurs des signaux radio démodulés, et le signal reconstruit, i.e. les valeurs absolues des valeurs des signaux radio démodulés quantifiées et dé-quantifiées.

La figure 9 illustre schématiquement des étapes pour déterminer la table de quantification utilisée dans le procédé de quantification selon un autre mode particulier de réalisation de l'invention.

Selon ce mode particulier de réalisation de l'invention, la ou les tables de quantification sont déterminées de sorte à ne pas dégrader les performances globales du codage canal, mesurées par le bloc BLER (pour Bloc Error Rate en anglais). Notamment, selon ce mode particulier de réalisation, une détermination de la table de quantification est réalisée lors de la phase d'apprentissage selon une optimisation de bout en bout tenant compte de la performance globale du codage canal. Selon ce mode particulier de réalisation de l'invention, la chaîne complète de décodage est intégrée dans la boucle d'optimisation, afin de trouver les paramètres optimaux pour le critère de qualité du décodage des LLRs. En raison de sa structure (Turbo-Decoder, LDPC, Polar Codes), la qualité de décodage est une fonction non dérivable des paramètres d'entrée qui sont les pas de quantification des LLRs. Ainsi, toute méthode classique d'optimisation à base de descente de gradient est exclue.

Des méthodes "sans gradient" sont utilisées, comme par exemple les algorithmes génétiques, mais d'autres méthodes d'optimisation sont envisageables (par exemple recuit simulé). Dans ces méthodes, on considère un ensemble de vecteurs de l'espace de paramètres qui sont des "candidats", et une "fonction d'adéquation" définie sur cet espace, qu'on cherche à maximiser. Un vecteur de l'espace de paramètres correspond à une table de quantification définissant les intervalles de quantifications ou pas de quantification pour quantifier les valeurs du signal LLR. Selon ce mode particulier de réalisation, la table de quantification est déterminée pour un niveau de codage canal déterminé à partir d'un ensemble de signaux LLRs d'apprentissage. Selon différentes variantes, une table de quantification unique peut être déterminée pour tous les niveaux de codage canal, ou bien une table de quantification peut être déterminée pour chaque niveau de codage canal. On décrit ici la variante selon laquelle une table de quantification est déterminée pour chaque niveau de codage canal.

L'ensemble de signaux LLRs d'apprentissage utilisé dans le processus d'optimisation décrit ci-dessous correspond à des signaux radio, classiquement des symboles I/Q, transmis selon le niveau de codage canal considéré et démodulé pour fournir un signal démodulé sous la forme de soft bits ou LLRs. Chaque valeur de ce signal démodulé correspond à un rapport de vraisemblance logarithmique d'un symbole du signal radio reçu par l'antenne.

Lors d'une étape E90, un ensemble de vecteurs de quantification candidats est déterminé. A l'initialisation, on détermine donc un ensemble de tables de quantification candidates, par exemple par une méthode de type « companding ».

Puis, pour chaque vecteur de quantification candidat, lors d'une étape E91, les signaux LLRs d'apprentissage sont quantifiés à l'aide du vecteur de quantification candidat, fournissant des signaux LLRs d'apprentissage quantifiés.

Lors d'une étape E92, les signaux LLRs d'apprentissage quantifiés sont décodés selon le niveau de codage canal. Préalablement au décodage canal, ces signaux LLRs d'apprentissage quantifiés sont dé-quantifiés.

Lors d'une étape E93, une erreur est calculée entre les signaux LLRs d'apprentissage quantifiés décodés et les signaux LLRs d'apprentissage décodés non quantifiés, selon la fonction d'adéquation choisie.

Lors d'une étape E95, on sélectionne le vecteur de quantification de l'ensemble des vecteurs de quantification candidats qui minimise l'erreur entre les signaux LLRs d'apprentissage quantifiés décodés et les signaux LLRs d'apprentissage décodés non quantifiés.

Selon une variante de ce mode particulier de réalisation de l'invention, la phase d'optimisation est basée sur un algorithme génétique. Selon ce mode particulier de réalisation de l'invention, le vecteur de quantification est sélectionné à l'étape E95, si un critère d'arrêt de l'algorithme est satisfait. Un tel critère d'arrêt peut comprendre un nombre maximal d'itérations de l'algorithme atteint, un critère de convergence de l'algorithme atteint.

Si le critère d'arrêt n'est pas atteint, lors d'une étape E94, une optimisation des vecteurs de quantification candidats est réalisée, et le procédé itère les étapes E91-E93 pour le nouvel ensemble de vecteurs de quantification candidats.

Dans le cas des algorithmes génétiques tels qu'utilisés dans l'invention, on fait "évoluer" l'ensemble de vecteurs de quantification candidats comme une "population d'individus" en appliquant des principes tirés de la théorie de l'évolution: probabilité de reproduction proportionnelle à la fonction d'adéquation, mutations aléatoires, hybridations aléatoires. Une telle méthode produit une amélioration progressive de l'adéquation du meilleur vecteur de quantification candidat. A la convergence, on a un optimum local.

La mise en œuvre de cette variante consiste à utiliser une méthode « sans gradient » e.g., l'algorithme génétique sur un jeu de données représentatif, ici les signaux LLRs d'apprentissage. La fonction d'adéquation est une évaluation de la performance d'un décodeur du type considéré (Turbo/LDPC/Polar), et déterminé par le niveau de codage canal MCS considéré. Le grand nombre d'évaluations nécessaires (nombreux individus et générations) peut nécessiter le recours à du matériel accéléré pour le décodage, pendant cette phase d'optimisation.

Mais une fois la convergence obtenue ou le critère d'arrêt satisfait, le vecteur de quantification candidat optimal est extrait, pour chaque MCS, et lors d'une étape E96, mémorisé par le module de démodulation.

Ce vecteur de quantification optimal est ensuite exploité dans un système temps réel : il s'agit d'une table de quantification.

La variante décrite en relation avec la figure 9 est décrite dans le cas de la minimisation du BLER. Selon une variante, le procédé d'optimisation décrit en figure 9 peut être mis en œuvre en minimisant l'erreur entre les signaux LLRs d'apprentissage fournis en entrée et les signaux LLRs d'apprentissage quantifiés et déquantifiés. Selon cette variante, il n'est pas nécessaire de procéder au décodage canal des signaux LLRs d'apprentissage quantifiés. Cette variante est plus simple en termes de coût calculatoire, mais le vecteur de quantification sélectionné ne tient pas compte des performances du décodage canal.

La figure 10 illustre schématiquement des étapes du procédé de quantification inverse selon un mode particulier de réalisation de l'invention. Lorsque le module de décodage canal reçoit le signal LLRs quantifiés selon le procédé décrit en relation avec la figure 4A, le module de décodage canal doit réaliser la quantification inverse du signal quantifié.

Pour cela, lors d'une étape E100, le module de décodage canal reçoit le signal démodulé quantifié en provenance du module de démodulation.

Lors d'une étape E101, le module de décodage canal réalise la quantification scalaire inverse de chaque valeur dudit signal démodulé quantifié à l'aide d'une table de dé-quantification sélectionnée en fonction du niveau de codage canal utilisé pour transmettre le signal radio d'où provient le signal LLRs. La quantification inverse consiste à remplacer chaque index ou pas de quantification du signal quantifié par sa valeur « réelle », c'est-à-dire la valeur représentant l'intervalle de quantification associé au pas de quantification. Le signal démodulé dé-quantifié est ainsi obtenu.

Lors d'une étape E102, le module de décodage canal décodage le signal démodulé dé-quantifié.

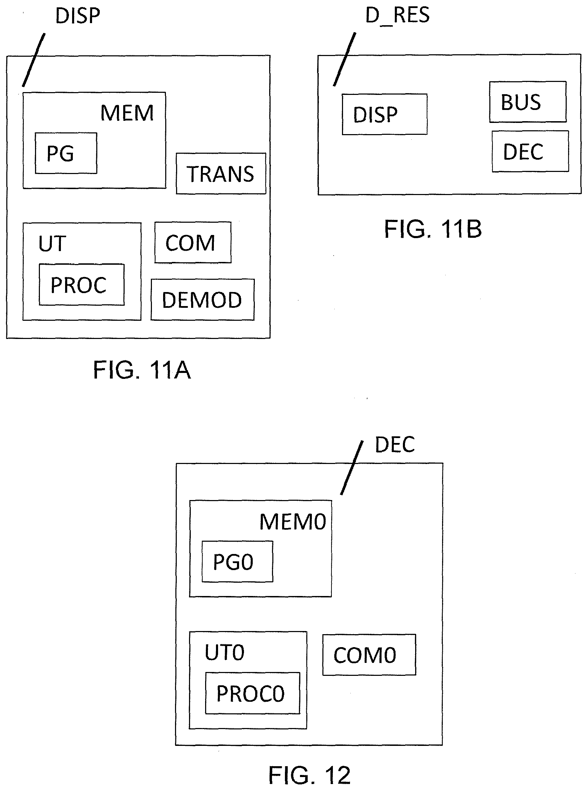

La figure 11A présente la structure simplifiée d'un dispositif de quantification DISP adapté pour mettre en œuvre le procédé de quantification selon l'un quelconque des modes particuliers de réalisation de l'invention.

Selon un mode particulier de réalisation de l'invention, les étapes du procédé de quantification sont mises en œuvre par des instructions de programme d'ordinateur. Pour cela, le dispositif DISP a l'architecture classique d'un ordinateur et comprend notamment une mémoire MEM, une unité de traitement UT, équipée par exemple d'un processeur PROC, et pilotée par le programme d'ordinateur PG stocké en mémoire MEM. Le programme d'ordinateur PG comprend des instructions pour mettre en œuvre les étapes du procédé de quantification tel que décrit ci-dessus, lorsque le programme est exécuté par le processeur PROC.

A l'initialisation, les instructions de code du programme d'ordinateur PG sont par exemple chargées dans une mémoire avant d'être exécutées par le processeur PROC. Le processeur PROC de l'unité de traitement UT met notamment en œuvre les étapes du procédé de quantification décrit ci-dessus, selon les instructions du programme d'ordinateur PG.

Le dispositif DISP comprend notamment une interface COM pour recevoir un signal radiofréquence et un module de démodulation radiofréquence DEMOD configuré pour démoduler le signal radiofréquence. Le module de démodulation DEMOD peut être sous la forme de modules logiciels ou de circuits dédiés.

Le dispositif DISP comprend également un module de transmission TRANS configurer pour transmettre le signal démodulé quantifié à un module de décodage canal situé dans un équipement distinct. Par exemple, le module de transmission TRANS est configuré pour transmettre le signal démodulé quantifié via un réseau fronthaul d'un réseau de données.

La mémoire MEM du dispositif DISP est configurée pour stocker une ou des tables de quantification pour quantifier les signaux démodulés.

Selon un mode particulier de réalisation de l'invention, le dispositif de quantification est compris dans un serveur.

La figure 11B présente la structure simplifiée d'un dispositif de réseau mobile D_RES comprenant au moins un dispositif de quantification DISP adapté pour mettre en œuvre le procédé de quantification selon l'un quelconque des modes particuliers de réalisation de l'invention.

Ce dispositif de réseau mobile D_RES comprend en outre au moins un dispositif de décodage canal DEC sous la forme d'un circuit programmable configuré pour mettre en œuvre un schéma de décodage canal du signal démodulé dé-quantifié, et au moins un bus de communication BUS apte à transmettre le signal démodulé quantifié depuis le dispositif de quantification vers le dispositif de décodage canal.

Selon un mode particulier de réalisation de l'invention, le dispositif de réseau mobile est compris dans un serveur.

La figure 12 illustre schématiquement un dispositif de décodage canal DEC selon un mode particulier de réalisation de l'invention.

Selon un mode particulier de réalisation de l'invention, les étapes du procédé de quantification inverses sont mises en œuvre par des instructions de programme d'ordinateur. Pour cela, le dispositif DEC a l'architecture classique d'un ordinateur et comprend notamment une mémoire MEM0, une unité de traitement UT0, équipée par exemple d'un processeur PROC0, et pilotée par le programme d'ordinateur PG0 stocké en mémoire MEM0. Le programme d'ordinateur PG0 comprend des instructions pour mettre en œuvre les étapes du procédé de quantification inverse tel que décrit ci-dessus, lorsque le programme est exécuté par le processeur PROC0. A l'initialisation, les instructions de code du programme d'ordinateur PG0 sont par exemple chargées dans une mémoire avant d'être exécutées par le processeur PROC0. Le processeur PROC0 de l'unité de traitement UT0 met notamment en œuvre les étapes du procédé de quantification inverse décrit ci-dessus, selon les instructions du programme d'ordinateur PG0. Le dispositif DEC comprend également une interface COM0 configurée pour recevoir un signal démodulé quantifié.

Le dispositif DEC est également configuré pour mettre en œuvre un schéma de décodage canal pour décoder le signal dé-quantifié. Le schéma de décodage canal peut être sous la forme de modules logiciels ou de circuits dédiés.

La mémoire MEM du dispositif DEC est configurée pour stocker une ou des tables de dé-quantification pour dé-quantifier les signaux démodulés quantifiés.

Selon un mode particulier de réalisation de l'invention, le dispositif de DEC est compris dans un serveur.

## Revendications

1. Procédé de quantification de données représentatives d'un signal radio reçu par une antenne radio d'un réseau mobile, comprenant :
- la démodulation dudit signal radio reçu par ladite antenne, fournissant un signal démodulé,
- la quantification scalaire de chaque valeur dudit signal démodulé à l'aide d'une table de quantification sélectionnée en fonction d'un niveau de codage canal utilisé pour transmettre ledit signal radio, fournissant un signal démodulé quantifié,
- la transmission dudit signal démodulé quantifié à un module de décodage canal ; **caractérisé en ce qu'**il comprend une étape préalable de détermination, pour chaque niveau de codage canal, d'au moins une table de quantification scalaire à partir d'un ensemble de signaux radio d'apprentissage.

2. Procédé selon la revendication 1 dans lequel chaque valeur dudit signal démodulé est représentative d'un rapport de vraisemblance logarithmique d'un symbole dudit signal radio reçu par ladite antenne.

3. Procédé selon la revendication 1 ou 2 dans lequel le niveau de codage canal correspond à un index représentatif d'une combinaison d'un schéma de modulation et d'un taux de codage canal.

4. Procédé selon l'une quelconque des revendications 1 à 3, dans lequel la détermination de ladite au moins une table de quantification scalaire comprend une minimisation d'un taux d'erreur de décodage canal des signaux radio d'apprentissage.

5. Procédé selon l'une quelconque des revendications 1 à 3, dans lequel la détermination de ladite au moins une table de quantification scalaire comprend:
- l'estimation d'une distribution de la valeur absolue des valeurs du signal radio démodulé, et,
- pour au moins un niveau de quantification correspondant à une représentation des valeurs quantifiées du signal démodulé quantifié sur un nombre déterminé de bits, le calcul d'intervalles de quantification à partir de ladite distribution estimée, chaque intervalle de quantification comprenant sensiblement un même nombre de valeurs du signal radio démodulé.

6. Procédé selon l'une quelconque des revendications 1 à 3, dans lequel la détermination de ladite au moins une table de quantification scalaire est réalisée à l'aide d'une méthode de type Lloyd-Max.

7. Procédé selon l'une quelconque des revendications 1 à 4, dans lequel la détermination de ladite au moins une table de quantification scalaire comprend les sous-étapes suivantes :
- détermination d'un ensemble de vecteurs de quantification candidats, et
- pour chaque vecteur de quantification candidat :
- quantification des signaux radio démodulés d'apprentissage à l'aide dudit vecteur de quantification, fournissant des signaux radio démodulés d'apprentissage quantifiés,
- calcul d'une distorsion à partir desdits signaux radio démodulés d'apprentissage quantifiés,
- sélection du vecteur de quantification dudit ensemble minimisant ladite distorsion.

8. Procédé selon la revendication 7, la détermination de ladite au moins une table de quantification scalaire comprenant en outre le décodage desdits signaux radio démodulés d'apprentissage quantifiés selon le niveau de codage canal déterminé, et dans lequel la distorsion est calculée entre lesdits signaux radio démodulés d'apprentissage quantifiés décodés et lesdits signaux radio démodulés d'apprentissage décodés non quantifiés.

9. Procédé selon la revendication 7 ou 8, dans lequel les sous-étapes sont itérées et à chaque itération, ledit ensemble de vecteurs de quantification candidats est modifié selon un algorithme génétique.

10. Procédé selon l'une quelconque des revendications 5 ou 6, dans lequel au moins deux tables de quantification scalaire sont respectivement déterminées pour au moins deux niveaux de quantification, le procédé comprend en outre la sélection d'un niveau de quantification parmi les au moins deux niveaux de quantification, minimisant un coût débit-distorsion, où le débit correspond au débit utilisé pour représenter les valeurs quantifiées et la distorsion est calculée entre les valeurs du signal radio démodulé et les valeurs quantifiées.

11. Procédé de quantification inverse d'un signal démodulé quantifié, comprenant :
- la réception du signal démodulé quantifié en provenance d'un module de démodulation configuré pour démoduler un signal radio reçu par une antenne radio d'un réseau mobile,
- la quantification scalaire inverse de chaque valeur dudit signal démodulé quantifié à l'aide d'une table de dé-quantification sélectionnée en fonction d'un niveau de codage canal utilisé pour transmettre ledit signal radio, fournissant un signal démodulé dé-quantifié,
- le décodage canal dudit signal démodulé dé-quantifié,
**caractérisé en ce que** pour chaque niveau de codage canal est préalablement déterminée au moins une table de quantification scalaire à partir d'un ensemble de signaux radio d'apprentissage.

12. Dispositif (DISP) de quantification de données représentatives d'un signal radio reçu par une antenne radio d'un réseau mobile, comprenant :
- un module de démodulation (DEMOD) configuré pour démoduler ledit signal radio reçu par ladite antenne, fournissant un signal démodulé ,
- un processeur (PROC) et une mémoire (MEM) configurés pour quantifier chaque valeur dudit signal démodulé à l'aide d'une table de quantification scalaire sélectionnée en fonction d'un niveau de codage canal utilisé pour transmettre ledit signal radio, fournissant un signal démodulé quantifié,
- un module de transmission (TRANS) configuré pour transmettre ledit signal démodulé quantifié à un module de décodage canal,
au moins une table de quantification scalaire étant déterminée pour chaque niveau de codage canal à partir d'un ensemble de signaux radio d'apprentissage.

13. Dispositif (DEC) de décodage canal comprenant :
- un récepteur (COM0) d'un signal démodulé quantifié en provenance d'un module de démodulation configuré pour démoduler un signal radio reçu par une antenne radio d'un réseau mobile,
- un processeur (PROC0) et une mémoire (MEM0) configurés pour appliquer une quantification scalaire inverse à chaque valeur dudit signal démodulé quantifié à l'aide d'une table de dé-quantification sélectionnée en fonction d'un niveau de codage canal utilisé pour transmettre ledit signal radio, fournissant un signal démodulé dé-quantifié, et pour appliquer un décodage canal dudit signal démodulé dé-quantifié, au moins une table de quantification scalaire étant déterminée pour chaque niveau de codage canal à partir d'un ensemble de signaux radio d'apprentissage.

14. Dispositif (D_RES) d'un réseau mobile comprenant :
- au moins un dispositif de quantification (DISP) selon la revendication 12,
- au moins un dispositif (DEC) de décodage canal sous la forme d'un circuit programmable configuré pour mettre en oeuvre un schéma de décodage canal du signal démodulé dé-quantifié, et
- au moins un bus (BUS) de communication apte à transmettre le signal démodulé quantifié depuis le dispositif de quantification vers le dispositif de décodage canal.

## Patentansprüche

1. Verfahren zur Quantifizierung von Daten, die ein Funksignal darstellen, das durch eine Funkantenne eines Mobilnetzes empfangen wird, das Folgendes umfasst:
- Demodulation des durch die Antenne empfangenen Funksignals, die ein demoduliertes Signal liefert,
- Skalarquantifizierung jedes Werts des demodulierten Signals mit Hilfe einer Quantifizierungstabelle, die in Abhängigkeit von einem Kanalcodierungsniveau ausgewählt wird, das zum Übertragen des Funksignals verwendet wird, die ein quantifiziertes demoduliertes Signal liefert,
- Übertragung des quantifizierten demodulierten Signals zu einem Kanaldecodierungsmodul;
**dadurch gekennzeichnet, dass** es einen vorherigen Schritt zur Bestimmung mindestens einer Skalarquantifizierungstabelle anhand einer Menge von Lernfunksignalen für jedes Kanalcodierungsniveau umfasst.

2. Verfahren nach Anspruch 1, wobei jeder Wert des demodulierten Signals ein logarithmisches Wahrscheinlichkeitsverhältnis eines Symbols des durch die Antenne empfangenen Funksignals darstellt.

3. Verfahren nach Anspruch 1 oder 2, wobei das Kanalcodierungsniveau einem Index entspricht, der eine Kombination eines Modulationsschemas und eines Kanalcodierungsprozentsatzes darstellt.

4. Verfahren nach einem der Ansprüche 1 bis 3, wobei die Bestimmung der mindestens einen Skalarquantifizierungstabelle eine Minimierung eines Kanaldecodierungsfehlerprozentsatzes der Lernfunksignale umfasst.

5. Verfahren nach einem der Ansprüche 1 bis 3, wobei die Bestimmung der mindestens einen Skalarquantifizierungstabelle Folgendes umfasst:
- Abschätzung einer Verteilung des Absolutwerts der Werte des demodulierten Funksignals und
- für mindestens ein Quantifizierungsniveau, das einer Darstellung der quantifizierten Werte des quantifizierten demodulierten Signals an einer bestimmten Anzahl von Bits entspricht, Berechnung von Quantifizierungsintervallen anhand der abgeschätzten Verteilung, wobei jedes Quantifizierungsintervall im Wesentlichen die gleiche Anzahl von Werten des demodulierten Funksignals enthält.

6. Verfahren nach einem der Ansprüche 1 bis 3, wobei die Bestimmung der mindestens einen Skalarquantifizierungstabelle mit Hilfe einer Methode des Lloyd-Max-Typs ausgeführt wird.

7. Verfahren nach einem der Ansprüche 1 bis 4, wobei die Bestimmung der mindestens einen Skalarquantifizierungstabelle die folgenden Unterschritte umfasst:
- Bestimmung einer Menge von Kandidatenquantifizierungsvektoren, und
- für jeden Kandidatenquantifizierungsvektor:
- Quantifizierung der demodulierten Lernfunksingale mit Hilfe des Quantifizierungsvektors, die quantifizierte demodulierte Lernfunksignale liefert,
- Berechnung einer Verzerrung anhand der quantifizierten demodulierten Lernfunksignale,
- Auswahl des Quantifizierungsvektors der Menge, der die Verzerrung minimiert.

8. Verfahren nach Anspruch 7, wobei die Bestimmung der mindestens einen Skalarquantifizierungstabelle außerdem die Decodierung der quantifizierten demodulierten Lernfunksignale gemäß dem bestimmten Kanalcodierungsniveau umfasst und wobei die Verzerrung zwischen den decodierten quantifizierten demodulierten Lernfunksignalen und den nicht quantifizierten decodierten demodulierten Lernfunksignalen berechnet wird.

9. Verfahren nach Anspruch 7 oder 8, wobei die Unterschritte iteriert werden und bei jeder Iteration die Menge von Kandidatenquantifizierungsvektoren gemäß einem genetischen Algorithmus modifiziert wird.

10. Verfahren nach einem der Ansprüche 5 oder 6, wobei mindestens zwei Skalarquantifizierungstabellen jeweils für mindestens zwei Quantifizierungsniveaus bestimmt werden, wobei das Verfahren außerdem die Auswahl eines Quantifizierungsniveaus unter den mindestens zwei Quantifizierungsniveaus umfasst, das Durchsatz-Verzerrungs-Kosten minimiert, wobei der Durchsatz dem Durchsatz entspricht, der zum Darstellen der quantifizierten Werte verwendet wird, und die Verzerrung zwischen den Werten des demodulierten Funksignals und den quantifizierten Werten berechnet wird.

11. Verfahren zur inversen Quantifizierung eines quantifizierten demodulierten Signals, das Folgendes umfasst:
- Empfang des quantifizierten demodulierten Signals, das von einem Demodulierungsmodul stammt, das zum Demodulieren eines durch eine Funkantenne eines Mobilnetzes empfangenen Funksignals konfiguriert ist,
- inverse Skalarquantifizierung jedes Werts des quantifizierten demodulierten Signals mit Hilfe einer Entquantifizierungstabelle, die in Abhängigkeit von einem Kanalcodierungsniveau ausgewählt wird, das zum Übertragen des Funksignals verwendet wird, die ein entquantifiziertes demoduliertes Signal liefert,
- Kanaldecodierung des entquantifizierten demodulierten Signals,
**dadurch gekennzeichnet, dass** für jedes Kanalcodierungsniveau vorher mindestens eine Skalarquantifizierungstabelle anhand einer Menge von Lernfunksignalen bestimmt wird.

12. Vorrichtung (DISP) zur Quantifizierung von Daten, die ein Funksignal darstellen, das durch eine Funkantenne eines Mobilnetzes empfangen wird, die Folgendes umfasst:
- ein Demodulierungsmodul (DEMOD), das zum Demodulieren des durch die Antenne empfangenen Funksignals konfiguriert ist und das ein demoduliertes Signal liefert,
- einen Prozessor (PROC) und einen Speicher (MEM), die zum Quantifizieren jedes Werts des demodulierten Signals mit Hilfe einer Skalarquantifizierungstabelle konfiguriert sind, die in Abhängigkeit von einem Kanalcodierungsniveau ausgewählt wird, das zum Übertragen des Funksignals verwendet wird, die ein quantifiziertes demoduliertes Signal liefern,
- ein Übertragungsmodul (TRANS), das zum Übertragen des quantifizierten demodulierten Signals zu einem Kanaldecodierungsmodul konfiguriert ist,
mindestens eine Skalarquantifizierungstabelle, die für jedes Kanalcodierungsniveau anhand einer Menge von Lernfunksignalen bestimmt wird.

13. Vorrichtung (DEC) zur Kanaldecodierung, die Folgendes umfasst:
- einen Empfänger (COM0) eines quantifizierten demodulierten Signals, das von einem Demodulierungsmodul stammt, der zum Demodulieren eines durch eine Funkantenne eines Mobilnetzes empfangenen Funksignals konfiguriert ist,
- einen Prozessor (PROC0) und einen Speicher (MEMO), die zum Anwenden einer inversen Skalarquantifizierung auf jeden Wert des quantifizierten demodulierten Signals mit Hilfe einer Entquantifizierungstabelle, die in Abhängigkeit von einem Kanalcodierungsniveau ausgewählt wird, das zum Übertragen des Funksignals verwendet wird, die ein entquantifiziertes demoduliertes Signal liefert, und zum Anwenden einer Kanaldecodierung des entquantifizierten demodulierten Signals konfiguriert sind, wobei mindestens eine Skalarquantifizierungstabelle für jedes Kanalcodierungsniveau anhand einer Menge von Lernfunksignalen bestimmt wird.

14. Vorrichtung (D_RES) eines Mobilnetzes, die Folgendes umfasst:
- mindestens eine Vorrichtung (DISP) zur Quantifizierung nach Anspruch 12,
- mindestens eine Vorrichtung (DEC) zur Kanaldecodierung in Form einer programmierbaren Schaltung, die dazu konfiguriert ist, ein Kanaldecodierungsschema des entquantifizierten demodulierten Signals auszuführen, und
- mindestens einen Kommunikationsbus (BUS), der das quantifizierte demodulierte Signal von der Vorrichtung zur Quantifizierung an die Vorrichtung zur Kanaldecodierung übertragen kann.

## Claims

1. Method for quantizing data which are representative of a radio signal which is received by a radio antenna of a mobile network, comprising:
- demodulating said radio signal received by said antenna, providing a demodulated signal,
- scalarly quantizing each value of said demodulated signal using a quantization table selected depending on a channel coding level used to transmit said radio signal, providing a quantized demodulated signal,
- transmitting said quantized demodulated signal to a channel decoding module;
**characterized in that** it comprises a previous step of determining, for each channel coding level, at least one scalar quantization table on the basis of a set of training radio signals.

2. Method according to Claim 1, wherein each value of said demodulated signal is representative of a logarithmic likelihood ratio of a symbol of said radio signal received by said antenna.

3. Method according to Claim 1 or 2, wherein the channel coding level corresponds to an index which is representative of a combination of a modulation scheme and a channel coding rate.

4. Method according to any one of Claims 1 to **3,** wherein determining said at least one scalar quantization table comprises minimizing a channel decoding error rate for the training radio signals.

5. Method according to any one of Claims 1 to 3, wherein determining said at least one scalar quantization table comprises:
- estimating a distribution of the absolute value of the values of the demodulated radio signal, and,
- for at least one quantization level corresponding to a representation of the quantized values of the demodulated signal which is quantized over a determined number of bits, calculating quantization intervals on the basis of said estimated distribution, each quantization interval comprising substantially the same number of values of the demodulated radio signal.

6. Method according to any one of Claims 1 to 3, wherein said at least one scalar quantization table is determined using a Lloyd-Max method.

7. Method according to any one of Claims 1 to 4, wherein determining said at least one scalar quantization table comprises the following substeps:
- determining a set of candidate quantization vectors, and
- for each candidate quantization vector:
- quantizing the training demodulated radio signals using said quantization vector, providing quantized training demodulated radio signals,
- calculating a distortion on the basis of said quantized training demodulated radio signals,
- selecting the quantization vector from said set which minimizes said distortion.

8. Method according to Claim 7, determining said at least one scalar quantization table further comprising decoding said quantized training demodulated radio signals according to the determined channel coding level, and wherein the distortion is calculated between said decoded quantized training demodulated radio signals and said unquantized decoded training demodulated radio signals.

9. Method according to Claim 7 or 8, wherein the substeps are iterated and, at each iteration, said set of candidate quantization vectors is modified according to a genetic algorithm.

10. Method according to either one of Claims 5 and 6, wherein at least two scalar quantization tables are respectively determined for at least two quantization levels, the method further comprising selecting one quantization level from among the at least two quantization levels, minimizing a rate-distortion cost, where the rate corresponds to the rate used to represent the quantized values and the distortion is calculated between the values of the demodulated radio signal and the quantized values.

11. Method for inversely quantizing a quantized demodulated signal, comprising:
- receiving the quantized demodulated signal originating from a demodulation module configured to demodulate a radio signal received by a radio antenna of a mobile network,
- inversely scalarly quantizing each value of said quantized demodulated signal using a dequantization table selected depending on a channel coding level used to transmit said radio signal, providing a dequantized demodulated signal,
- channel decoding said dequantized demodulated signal,
**characterized in that**, for each channel coding level, at least one scalar quantization table is determined previously on the basis of a set of training radio signals.

12. Device (DISP) for quantizing data which are representative of a radio signal received by a radio antenna of a mobile network, comprising:
- a demodulation module (DEMOD) configured to demodulate said radio signal received by said antenna, providing a demodulated signal,
- a processor (PROC) and a memory (MEM) which are configured to quantize each value of said demodulated signal using a scalar quantization table selected depending on a channel coding level used to transmit said radio signal, providing a quantized demodulated signal,
- a transmission module (TRANS) configured to transmit said quantized demodulated signal to a channel decoding module,
at least one scalar quantization table being determined for each channel coding level on the basis of a set of training radio signals.

13. Channel decoding device (DEC) comprising:
- a receiver (COM0) of a quantized demodulated signal originating from a demodulation module configured to demodulate a radio signal received by a radio antenna of a mobile network,
- a processor (PROC0) and a memory (MEMO) which are configured to apply inverse scalar quantization to each value of said quantized demodulated signal using a dequantization table selected depending on a channel coding level used to transmit said radio signal, providing a dequantized demodulated signal, and to apply channel decoding of said dequantized demodulated signal, at least one scalar quantization table being determined for each channel coding level on the basis of a set of training radio signals.

14. Device (D_RES) of a mobile network, comprising:
- at least one quantization device (DISP) according to Claim 12,
- at least one channel decoding device (DEC) in the form of a programmable circuit configured to implement a channel decoding scheme for the dequantized demodulated signal, and
- at least one communication bus (BUS) which is able to transmit the quantized demodulated signal from the quantization device to the channel decoding device.
